# EUROPEAN PATENT APPLICATION

(11) **EP 1 257 006 A1**
(43) Date of publication of application: **13.11.2002**
(21) Application number: 02253215.4
(22) Date of filing: 08.05.2002
(51) Int. Cl.: H01R 13/24

(54) **An electrical interconnect assembly**

(30) Priority: 09.05.2001 GB 0111308
(71) Applicant: Tyco Electronics UK Limited, Stanmore, Middlesex HA7 4RS (GB)
(72) Inventor: Whelan, Michael Joseph Gerard, Bedfordshire SG18 9PS (GB)
(74) Representative: Warren, Keith Stanley

(57) **Abstract**

An interconnect assembly (3) for an electrical device, such as a piezoelectric device (1), that has an array of spaced contacts (7) commonly connected to external circuitry, comprises a conductive elastomeric rod (5) spanning the contacts (7) and urged into engagement with the contacts (7) by an insulating housing (6), and a bus bar (8,9) electrically contacting the conductive rod (5) for electrically connecting the conductive rod (5) to the external circuitry. The bus bar (8,9) is mounted on the outside of the housing (6) and has a contact portion (14,15) at one end extending through an opening (18) in the housing (6) to engage the conductive rod (5), and a terminal (10,11) at its opposite end for facilitating connection to the external circuitry. The bus bar (8,9) is retained in position by a plastics sleeve (25) surrounding the housing (6).

## Description

The present invention relates to an interconnect assembly for an electrical device and, more specifically, to an interconnect assembly for an electrical device, such as a piezoelectric device, having one or more arrays of spaced electrical contacts in which each array is commonly connected to external circuitry associated with the device.

Several problems are associated with electrical devices that have a multiplicity of contacts and that are subject to continual repetitive displacements or vibration. One problem associated with these devices is the fracturing of conventional soldered connections to the contacts when subject to displacements or vibrations. For example, this problem could occur in the case of a piezoelectric device used to control a fuel injector of an internal combustion engine that is required to operate at a frequency in the range of 60 to 80 Hertz. Also, connections to an array of electrical contacts which are to be commonly connected to external circuitry are difficult to make with automated machinery when the contact points are not at a uniform pitch.

It is therefore desirable to provide an electrical interconnect assembly for an array of spaced contacts of an electrical device that is resilient and wear resistant so that it can withstand continual in-service displacements and vibration. It is also desirable to provide an interconnect assembly wherein the spacing of the contacts is immaterial so that assembly is facilitated.

The present invention is an interconnect assembly of an electrical device, such as a piezoelectric device, that has an array of spaced contacts commonly connected to external circuitry. The assembly has a conductive elastomeric rod spanning the contacts and urged into engagement therewith by an insulating support member. A conductor is in electrical contact with the conductive elastomeric rod for electrically connecting the conductive elastomeric rod and the contacts to the external circuitry.

The invention will now be described by way of example with reference to the accompanying drawings in which:
Figure 1 is an elevational view of a piezoelectric device of the present invention,
Figure 2 is an axial view of the device in Figure 1,
Figure 3 is an exploded view of the device, and
Figure 4 is a perspective view of a half housing of an insulating housing and a conductive elastomeric rod.

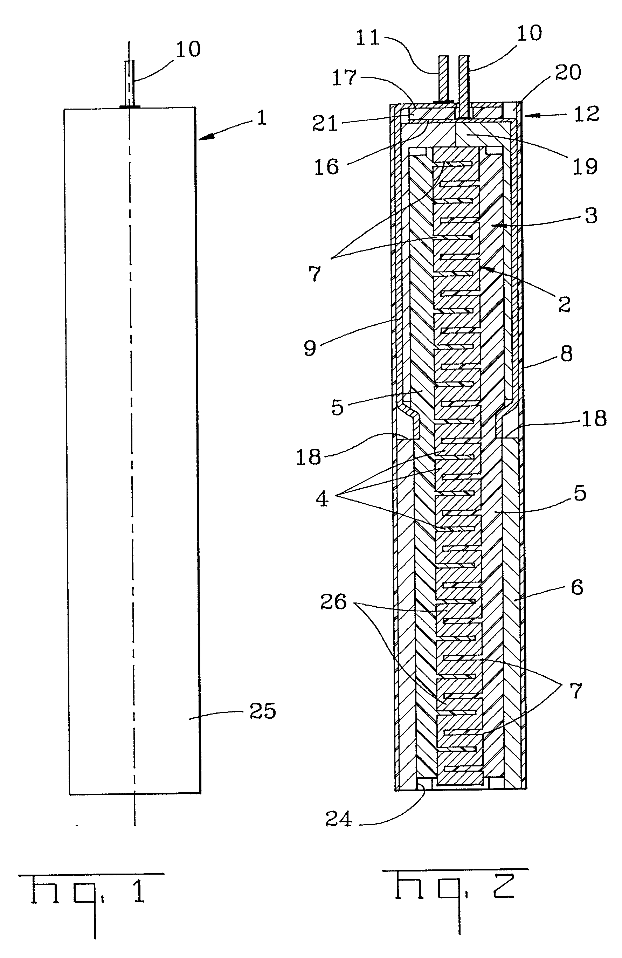

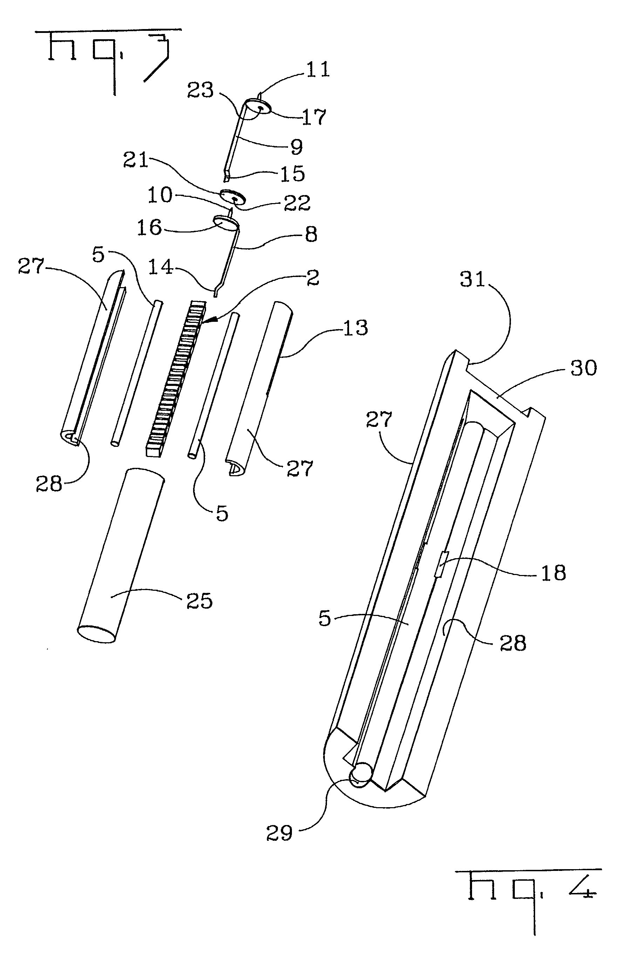

Referring to Figures 1 and 2, piezoelectric device 1 is designed to operate a fuel injector of an internal combustion engine and comprises a piezoelectric stack 2 of square cross-section and an interconnect assembly for connecting the electrodes 4 of the piezoelectric stack 2 to external electrical circuitry (not shown) for controlling the piezoelectric device 1.

Shown in Figure 2, the interconnect assembly 3 comprises a pair of conductive elastomeric rods 5 of circular cross-section, an insulating housing 6, and a pair of conductive bus bars 8,9. The insulating housing 6 supports the conductive elastomeric rods 5 against opposite sides of the piezoelectric stack 2 and urges the conductive elastomeric rods 5 into contact with contact portions 7 of the electrodes 4 disposed in columns along opposite sides of the piezoelectric stack 2. The bus bars 8,9 connect the conductive elastomeric rods 5 to terminal pins 10,11 at an upper end 12 of the piezoelectric device 1. Each bus bar 8,9 comprises a conductive metal strip that is seated in an axial groove 13 extending along an outside surface of the insulating housing 6. Shown in Figure 3, each bus bar 8, 9 has an inwardly extending contact portion 14,15 located at a lower end and a transverse circular plate portion 16,17 located at an opposite end mounting one of the terminal pins 10,11 which is welded to the transverse circular plate portion 16,17. Shown in Figure 2, the contact portions 14,15 of the bus bars 8,9 extend through openings 18 in a wall of the insulating housing 6 to engage the conductive elastomeric rods 5. The openings 18 are positioned approximately at an axial centre of the insulating housing 6.

Shown in Figure 2, the upper end 12 of the insulating housing 6 is closed by an end wall 19 having a circular cavity 20 on its outside. The transverse plate portions 16,17 of the bus bars 8,9 mounting the terminal pins 10,11 are disposed in the circular cavity 20 one above the other. Shown in Figure 3, the transverse plate portions 16,17 are separated from one another by a ceramic insulator disc 21. The terminal pin 10 of the lower transverse plate portion 16 projects through a hole 22 in the ceramic insulator disc 21 and a cooperating hole 23 in the upper plate portion 17. The hole 23 is oversized so as to avoid the terminal pin 10 projecting therethrough from short-circuiting against the upper plate portion 17. An end 24 of the insulating housing 6 opposite the terminal pins 10,11 is open to enable adjacent end of the piezoelectric stack 2 to act on an injection mechanism of the fuel injector. The whole piezoelectric device 1 is encased in an outer sleeve 25 of plastics material.

Shown in Figure 2, the piezoelectric stack 2 comprises a multiplicity of piezoelectric cells 26 that are sandwiched between the electrodes 4 and are formed from piezoelectric material, such as, ceramic piezoelectric material. The piezoelectric cells 26 provide alternate positive and negative electrodes 4 projecting into the material from opposite sides of the piezoelectric stack 2. The piezoelectric stack 2 is produced by growing the piezoelectric material and, at an appropriate predetermined pitch during the growth, by printing films of electrode material on the piezoelectric material. The piezoelectric stack 2 is finished by machining opposite sides of the piezoelectric stack 2 to expose edges of the electrode films. The edges form the spaced contacts or contact portions 7 for the electrodes 4 along opposite sides of the piezoelectric stack 2, respectively.

Shown in Figure 4, the insulating housing 6 is constructed from two semi-circular half housings 27 preferably made from ceramic material. Each half housing 27 has an internal axial recess 28 of substantially rectangular cross-section for accommodating half of a square section of the piezoelectric stack 2. An axial recess 29 of part circular cross-section is formed in the bottom of the substantially rectangular recess for mounting one of the conductive elastomeric rods 5. The part circular recess 29 subtends an angle of more than 180° so that it grips the elastomeric rod 5 when the elastomeric rod 5 is mounted lengthwise in the part circular recess 29 and leaves a sector of the elastomeric rod 5 protruding into the rectangular recess 28. At one end, each half housing 27 is closed by a semi-circular end wall portion 30 having an outside cavity 31 for forming the closed upper end 12 and the end cavity 20 of the complete insulating housing 6 shown in Figure 2 when the half housings 27 are assembled together. At its opposite end, each half housing 27 is open so as to form the open end 24 of the insulating housing 6 through which the piezoelectric stack 2 acts on the injection mechanism.

The elastomeric rods 5 preferably consist of an elastomeric former and a conductive mesh woven onto the former. Alternatively, the elastomeric rods 5 may be formed from a conductive rubber. In either case, the circular cross-section of the elastomeric rods 5 is of similar radius to the part circular recesses 29 of the half housings 27 so that the rods 5 can be captured in the part circular recesses 29. On its outside surface, each half housing 27 has the axial groove 13 for seating its associated bus bar 8,9 and the axial groove 13 terminates in the opening 18 which extends through the wall in the insulating housing 6 into the part circular recess 29 to enable the contact portion 14,15 of the bus bar 8,9 to project inside the insulating housing 6 and contact the conductive rod 5. Preferably, the contact portion 14,15 contacts the conductive rod 5 adjacent a central position lengthwise of the piezoelectric stack 2 so that an application of electrical pulses to the piezoelectric device 1 for energising the piezoelectric stack 2 is applied symmetrically. This reduces the risk of electrical damage to the piezoelectric stack 2.

When assembled together with adhesive to form the insulating housing 6, the two half housings 27 urge the conductive elastomeric rods 5 resiliently into contact with the edge contact portions 7 of the electrodes 4 at opposite sides of the piezoelectric stack 2. The bus bars 8,9 are seated in the axial grooves 13 on the outsides of the assembled insulating housing 6 with the contact portions 14, 15 projecting through the openings 18 so as to engage the conductive rods 5 on the inside of the insulating housing 6. The transverse plate portions 16,17 of the bus bars 8,9 are disposed in the end cavity 20 of the assembled insulating housing 6 with the ceramic insulator disc 21 therebetween. The assembled insulating housing 6 is then encased with the outer plastics sleeve 25 which retains the bus bars 8,9 in the grooves 13 in the outside of the insulating housing 6 and serves to oppose the load placed on the bus bars 8,9 by the conductive rods 5. The assembled piezoelectric device 1 can be connected by the terminals 10,11 to external circuitry for applying a potential difference across the electrodes 4 to energise the piezoelectric stack 2 which, via the open end 24 of the piezoelectric device 1, can control actuation of the fuel injector mechanism.

## Claims

1. An interconnect assembly (3) of an electrical device having an array of spaced contacts (7) commonly connected to external circuitry, **characterized by**:
a conductive elastomeric rod (5) spanning the contacts (7) and urged into engagement therewith by an insulating support member (6); and
a conductor (8,9) in electrical contact with the conductive elastomeric rod (5) for electrically connecting the conductive elastomeric rod (5) and the contacts (7) to the external circuitry.

2. The interconnect assembly (3) of claim 1, wherein the conductor (8,9) is externally mounted on the insulating support member (6) and extends through an opening (18) in the insulating support member (6) to contact the conductive elastomeric rod (5).

3. The interconnect assembly (3) of claim 2, wherein the conductor (8,9) is retained in position on the insulating support member (6) by a flexible insulating sleeve (25) surrounding the electrical device.

4. The interconnect assembly (3) of claim 2 or 3, wherein the conductor (8,9) has a first end having a contact portion extending through the opening (18) in the insulating support member (6) to contact the conductive elastomeric rod (5) and a second end having a terminal for connecting the conductor (8,9) to the external circuitry.

5. The interconnect assembly (3) of any one of the preceding claims wherein the insulating support member (6) has a recess for mounting the conductive elastomeric rod (5) lengthwise such that the conductive elastomeric rod (5) protrudes from the recess in the transverse direction in order to engage the contacts (7).

6. A piezoelectric device (1) **characterized by**:
a piezoelectric stack (2) having positive and negative electrodes (4) with respective contacts (7) aligned along different zones on the outside of the piezoelectric stack (2);
conductive elastomeric rods (5) spanning the respective contacts (7) of the positive and negative electrodes (4) ;
an insulating housing (6) urging the conductive rods (5) into engagement with the associated contacts (7); and
conductors (8,9) in electrical contact with the conductive elastomeric rods (5) for connecting the conductive elastomeric rods (5) to external circuitry.

7. The piezoelectric device (1) of claim 6, wherein the conductors (8,9) are externally mounted on the insulating housing (6) and extend through openings (18) therein to contact the associated conductive elastomeric rods (5).

8. The piezoelectric device (1) of claim 7, wherein the conductors (8,9) extend longitudinally along the outside of the insulating housing (6) and have one end having a contact portion extending through the associated opening to contact the conductive elastomeric rod (5) and an opposite end having a terminal for connecting the piezoelectric device (1) to the external circuitry.

9. The piezoelectric device (1) of claim 7 or 8, wherein the conductors (8,9) are retained against the outside of the insulating housing (6) by a flexible insulating sleeve (25) surrounding the insulating housing (6).

10. The piezoelectric device (1) of any one of the preceding claims 6 to 9, wherein the insulating housing (6) has an axial recess for mounting the conductive elastomeric rods (5) lengthwise such that the conductive elastomeric rods (5) protrude from the axial recesses in a transverse direction so as to engage the associated contacts (7).
